# EUROPÄISCHE PATENTSCHRIFT

(11) **EP 0 469 250 B1**
(45) Veröffentlichungstag und Bekanntmachung des Hinweises auf die Patenterteilung: **19.04.1995**
(21) Anmeldenummer: 91107361.7
(22) Anmeldetag: 07.05.1991
(51) Int. Cl.: H01H 3/20, H01H 21/22, H01H 3/04

(54) **Ausschwenkbare Bedieneinheit**
Pivoting control unit
Unité de commande pivotant

(30) Priorität: 30.07.1990 DE 9011181 U
(43) Veröffentlichungstag der Anmeldung: 05.02.1992
(73) Patentinhaber: GRUNDIG E.M.V. Elektro-Mechanische Versuchsanstalt Max Grundig holländ. Stiftung & Co. KG., D-90762 Fürth (DE)
(72) Erfinder: Hartig, Heinz, Grundig E.M.V., Max Grundig, W-8510 Fuerth (DE)

(56) Entgegenhaltungen:
- EP-A- 0 407 754
- US-A- 4 918 266

## Beschreibung

Die Erfindung betrifft eine ausschwenkbare Bedieneinheit für ein elektronisches Gerät.

Bedieneinheiten von elektronischen Geräten, wie Videorecorder, Fernsehgeräte, Audiogeräte, aber auch Waschmaschinen und Elektroherde, befinden sich in vielen Fällen, meist aus optischen oder Sicherheitsgründen, von der Außenseite des Gerätes nicht sichtbar und nicht zugänglich hinter einer vorzugsweise schwenkbaren Klappe.

Die Bedieneinheiten können dabei entweder direkt in der Klappe gelagert und damit bei ausgeschwenkter Klappe bedienbar oder Teil einer von der Klappe nur abgedeckten Bedienfront sein, die im Gerätechassis oder direkt auf eine Leiterplatte montiert ist.

Für den ersten Fall, in dem die Bedieneinheiten direkt in der Klappe gelagert sind, müssen von der beweglichen Klappe zum Gerät Verbindungen vorhanden sein, die in den meisten Fällen aus Kabeln oder Kabelbäumen bestehen.

Derartige Verbindungen sind jedoch in der Regel konstruktions-, arbeits- und kostenaufwendig. Eine gewisse Störanfälligkeit ist ebenso gegeben, wie sie von bewegten Kabeln bekannt ist.

In dem zweiten Fall, in dem die Bedieneinheiten Teil des Gerätes und von der Klappe nur abgedeckt sind, treffen die geschilderten Nachteile zwar nicht zu, doch überwiegt hier der Nachteil, daß der Zugang zu den immer mehr miniaturisierten Schaltaggregaten der Bedieneinheit nicht sehr bedienerfreundlich ist.

Der Erfindung liegt die Aufgabe zugrunde, eine Bedieneinheit für elektronische Geräte zu schaffen, die die geschilderten Nachteile nicht aufweist.

Diese Aufgabe wird durch die im Patentanspruch 1 genannten Merkmale gelöst. Die Unteransprüche kennzeichnen vorteilhafte Ausgestaltungen der Erfindung.

Der Vorteil der Erfindung besteht darin, daß zum einen eine preiswerte und relativ einfache Lagerung der Schaltaggregate auf einer Leiterplatte innerhalb des elektronischen Gerätes möglich und zum anderen ein leichter Zugang zur Bedieneinheit gewährleistet ist. Entsprechend dem Aufbau der Bedieneinheit gemäß der Erfindung ist außerdem eine Störanfälligkeit weitgehend vermieden.

Die Erfindung wird nachstehend anhand der Zeichnungen näher erläutert. Es zeigen:
- Figur 1: eine Teilansicht eines elektronischen Gerätes mit einer Bedieneinheit im Schnitt mit geschlossener Abdeckklappe,
- Figur 2: eine Darstellung gemäß Figur 1, jedoch mit teilweise geöffneter Abdeckklappe,
- Figur 3: eine Darstellung gemäß Figur 1, jedoch mit geöffneter Abdeckklappe.

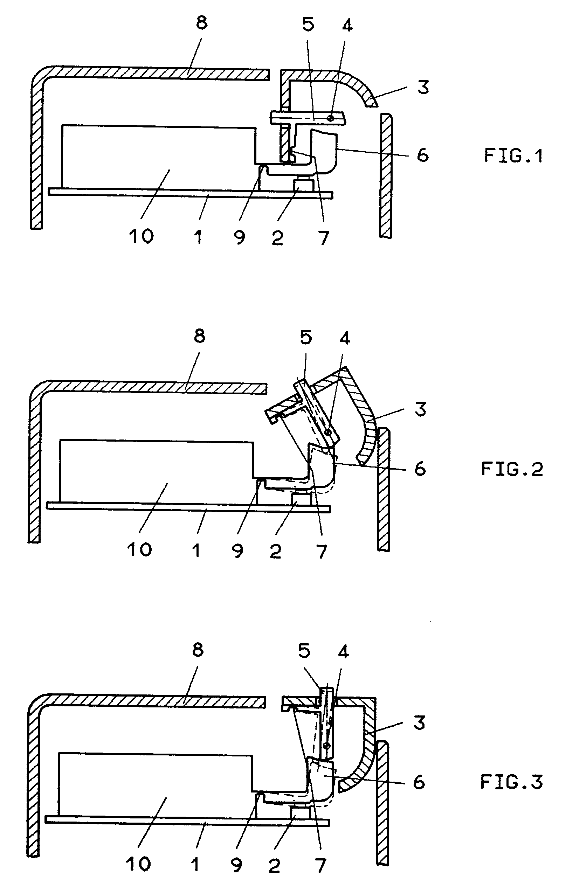

Die in Teilansicht in Figur 1 gezeigte Bedieneinheit besteht im wesentlichen aus einer an die Abdeckung 8 anschließende, um den Drehpunkt 4 schwenkbare Abdeckklappe 3, aus in dieser gelagertem Hubstößel 5, aus dem Verbindungsteil 6 und dem Schaltaggregat 2.

Das oder die Schaltaggregate 2 sind auf der Leiterplatte 1 montiert. Die Betätigung dieser Schaltaggregate erfolgt bei teilweiser oder ganz geöffneter Abdeckklappe 3 von den Hubstößeln 5 aus. Als Zwischenstücke zwischen den Hubstößeln 5 und den Schaltaggregaten 2 dienen Verbindungsteile 6.

Vorteilhafterweise sind die Verbindungsteile 6 Teil eines bereits vorhandenen Geräteteils 10 wie z. B. Display-Baustein, Bauteileträger oder Chassis und mit diesem einstückig gespritzt. Die federgelenkartige Anbindung 9 an dieses Geräteteil gibt den Verbindungsteilen 6 Lagerhebel-Charakteristik.

Auf ähnliche Art und Weise sind die Hubstößel 5 einstückig mit der Abdeckklappe 3 gespritzt. Die Verdünnung der Verbindungsstege 7 dient hierbei als Federgelenk und ist so ausgeführt, daß eine Bewegung der Hubstößel 5 vorzugsweise in deren Längsrichtung ermöglicht wird.

Vorteilhafter Weise kann die Bedieneinheit gemäß der Erfindung in verschiedenen Stellungen der teilweise oder ganz geöffneten Abdeckklappe betätigt werden. Eine ausschließlich in geöffnetem Zustand der Abdeckklappe gewünschte Betätigung der Bedieneinheit ist durch entsprechende Ausführung der Lagerung der Hubstößel 5 leicht möglich.

## Patentansprüche

1. Bedieneinheit für ein elektronisches Gerät, mit einer Abdeckklappe (3), in der ein in seiner Längsrichtung verschiebbarer Hubstößel (5) gelagert und die gegenüber einem auf einer Leiterplatte (1) sitzenden Schaltaggregat (2) und einem Verbindungsteil (6) derart schwenkbar ist, daß der Hubstößel (5) durch das Öffnen der Abdeckklappe (3) in eine Position gebracht wird, in der er bei längsseitiger Verschiebung über das Verbindungsteil (6) einen Kraftschluß zum Schaltaggregat (2) herstellt.

2. Bedieneinheit nach Anspruch 1,
**dadurch gekennzeichnet,** daß die Lagerung des Hubstößels (5) in der Abdeckklappe (3) so gestaltet ist, daß der Hubstößel (5) zumindest bei teilweiser oder ganz aufgeklappter Abdeckklappe (3) auf das Verbindungsteil (6) einwirken kann.

3. Bedieneinheit nach Anspruch 1,
**dadurch gekennzeichnet,** daß ein oder mehrere Verbindungsteile (6) vorhanden sind, die einstückig als Kunststoff-Spritzteil mit einem bereits vorhandenen Baustein (10) oder dem Gerätechassis hergestellt und über Scharnierverbindungen (9) mit diesem verbunden sind.

4. Bedieneinheit nach Anspruch 1,
**dadurch gekennzeichnet,** daß ein oder mehrere Hubstößel (5) vorhanden sind, die als Kunststoff-Spritzteile hergestellt und mit der Abdeckklappe (3) über Scharnierverbindungen (7) verbunden sind.

## Claims

1. Operating device for an electronic appliance, having a cover lid (3) in which a press plunger (5), which can be displaced in its longitudinal direction, is mounted and which can be pivoted with respect to a switching unit (2), located on a printed circuit board (1), and a connecting part (6) in such a manner that the press plunger (5), by opening the cover lid (3), is brought into a position in which it produces a force closure to the switching unit (2) in the case of displacement at the longitudinal side over the connecting part (6).

2. Operating device according to Claim 1, characterized in that the press plunger (5) is mounted in the cover lid (3) in such a manner that the press plunger (5) can act on the connecting part (6) at least when the cover lid (3) is partially or totally swung open.

3. Operating device according to Claim 1, characterized in that one or more connecting parts (6) are present which are integrally produced as an injection-moulded plastic part in conjunction with a module (10), which is already present, or with the appliance frame, and are connected thereto by means of hinge connections (9).

4. Operating unit according to Claim 1, characterized in that one or more press plungers (5) are present which are produced as injection-moulded plastic parts and are connected to the cover lid (3) by means of hinge connections (7).

## Revendications

1. Unité de commande pour un appareil électronique, comportant un abattant de fermeture (3), dans lequel est monté un poussoir (5) déplaçable dans la direction de sa longueur et qui peut basculer par rapport à une unité de commutation (2), qui est disposée sur une plaquette à circuits imprimés (1) et à un élément de liaison (6) de telle sorte que le poussoir (5) est amené, sous l'effet de l'ouverture de l'abattant de fermeture (3), dans une position dans laquelle, lors d'un déplacement longitudinal, il établit, par l'intermédiaire de l'élément de liaison (6), une liaison de force avec l'unité de commutation (2).

2. Unité de commande selon la revendication 1, caractérisée en ce que la position du poussoir (5) dans l'abattant de fermeture (3) est conçue de telle sorte que le poussoir (5) peut agir sur l'élément de liaison (6) au moins lorsque l'abattant de fermeture (3) est partiellement ou totalement rabattu.

3. Unité de commande selon la revendication 1, caractérisée en ce qu'il est prévu un ou plusieurs éléments de liaison (6), qui sont fabriqués d'un seul tenant sous la forme d'une pièce en matière plastique moulée par injection avec un module déjà existant (10) ou avec le châssis de l'appareil et est relié à ce dernier par l'intermédiaire de liaisons à charnière (9).

4. Unité de commande selon la revendication 1, caractérisée en ce qu'il est prévu un ou plusieurs poussoirs (5), qui sont réalisés sous la forme de pièces en matière plastique moulée par injection et sont reliés à l'abattant de fermeture (3) par l'intermédiaire de liaisons à charnière (7).
